# EUROPÄISCHE PATENTSCHRIFT

(11) **EP 1 110 277 B1**
(45) Veröffentlichungstag und Bekanntmachung des Hinweises auf die Patenterteilung: **12.06.2002**
(21) Anmeldenummer: 99953698.0
(22) Anmeldetag: 02.09.1999
(51) Int. Cl.: H01R 12/04, H01R 13/66, H01R 13/719

(54) **LEITERPLATTENANORDNUNG MIT MEHRPOLIGEM STECKVERBINDER**
PRINTED CIRCUIT BOARD ARRANGEMENT WITH A MULTIPOLE PLUG-IN CONNECTOR
ENSEMBLE PLAQUETTE DE CIRCUIT IMPRIME A CONNECTEUR ENFICHABLE MULTIPOLAIRE

(30) Priorität: 10.09.1998 DE 19841459
(43) Veröffentlichungstag der Anmeldung: 27.06.2001
(73) Patentinhaber: SIEMENS AKTIENGESELLSCHAFT, 80333 München (DE)
(72) Erfinder: BELAU, Horst, D-84085 Langquaid (DE); HELD, Joachim, D-81739 München (DE); REINDL, Hartwig, D-80537 Feucht (DE); MEYER, Wolfram, D-93051 Regensburg (DE)
(86) Internationale Anmeldenummer: DE9902785
(87) Internationale Veröffentlichungsnummer: WO0016446

(56) Entgegenhaltungen:
- WO-A-98/06243
- DE-A- 4 400 160
- DE-A- 4 425 803
- US-A- 5 736 910

## Beschreibung

Die Erfindung betrifft eine Leiterplattenanordnung mit mehrpoligem Steckverbinder mit den im Oberbegriff des Anspruches 1 angegebenen Merkmalen.

Die der Erfindung zugrundeliegende Problematik bezieht sich sowohl auf die Abschirmung von elektronischen Baugruppen gegen hochfrequente elektromagnetische Strahlungen von außen, wie z.B. Hochfrequenzeinstreuungen von Sendern oder Störungen durch Zünd- und Entladungsvorgänge, als auch auf die Verringerung der Emission von Hochfrequenz von der Baugruppe selbst, wie z. B. Hochfrequenz-Störströme auf den Versorgungsleitungen aufgrund von Microcontrollern in der Baugruppe. Während die gesamte Schaltungsanordnung als solche durch ein Metallgehäuse relativ einfach abgeschirmt werden kann, stellen dabei die das Gehäuse durchsetzenden Anschlüsse der Schaltung besondere Problemzonen dar. Zur Abschirmung werden dort entweder die Durchführungen der Anschlüsse durch Realisierung sogenannter Filter-Steckverbinder möglichst gut schirmend ausgeführt, wie dies beispielsweise in dem Fachaufsatz "Filter-Steckverbinder für die elektromagnetische Entstörung" von Matthias Weber und Hans-Peter Mayr (ATZ Automobiltechnische Zeitschrift 91 (1989), Seiten 588 bis 591) beschrieben ist. Dieser Steckverbinder ist als Planar-Tiefpaßfilter in Dickschichttechnik ausgebildet und weist voneinander durch eine dielektrische Schicht getrennte Signal- und Masseelektroden auf, die einander überlappen. Insoweit ist der Filter-Steckverbinder gemäß dem genannten Fachaufsatz relativ komplex aufgebaut.

In der EP 0 563 071 B1 ist ein gegen Hochfrequenz abschirmendes Gehäuse einer Schaltung, z. B. für die Steuerschaltung eines Air-Bags eines Fahrzeuges, beschrieben, bei der die Durchführung der Steckerstifte über einen vom übrigen Gehäuse getrennten und abgeschirmten Vorraum erfolgt.

Aus der WO 95/33291 A1 ist schließlich ein oberflächenmontierter Steckverbinder bekannt, bei dem die Steckerpins mit ihren abgekröpften platinenseitigen Enden flächig auf den entsprechenden Leiterbahnen der Platine aufgelötet sind.

Schließlich ist es auf dem einschlägigen technischen Gebiet üblich, zur Abschirmung von hochfrequenten Störungen Kondensatoren zwischen die ein- und ausgangsseitigen Signalleiterbahnen und entsprechende Masseleiterbahnen einer Leiterplattenanordnung zu setzen. Dabei können - wie dies beispielsweise auch in der bereits erwähnten EP 0 563 071 B1 zu sehen ist - die Steckerpins senkrecht auf die Platine zulaufen und in entsprechenden Kontaktbohrungen mit einer Signalleiterbahn verlötet sein. An diese Signalleiterbahnen sind jeweils Kondensatoren mit ihrem einen Anschlußpol angeschlossen, wobei der andere Anschlußpol auf einer gemeinsamen Massebahn liegt, die parallel vor dem Stecker liegt. Bei dieser Anordnung ist die Plazierung der Kondensatoren und die erzielbare Abschirmwirkung problematisch.

Aus der JP 8-306410 A ist bekannt, plattenartige Leiterenden auf einer Endfläche von parallelen Streifenleitern anzuordnen. Nur ein Teil des Leiterendes ragt aus einem Dielektrikum hervor, das einen Abschnitt des Leiterendes einbettet.

Aus der JP 9-46006 A ist eine Anordnung mit parallelen Mikrostreifenleitern bekannt, zwischen denen eine Masseleitung angeordnet ist. Die Leiter sind auf einem Dielektrikum angeordnet, das mit einer Masseschicht versehen ist. Die Masseleitung ist mit der Masseschicht verbunden.

Die DE 44 00 160 A1 betrifft eine Leiterplatte für ein Bussystem mit einer Vielzahl von Anschlußstellen für Leitungen, die an den Bus angekoppelt werden sollen. Eine Leiterfläche ist als Massefläche ausgebildet, die mit keinem anderen Potential des Systems verbunden ist. Die Anschlußstellen sind mit Filterkondensatoren versehen.

Die JP 1-138786 A offenbart einen integrierten Schaltkreis mit einer Abschirmschicht, die die signalführenden Leiter dreidimensional umgibt.

Aus der Patentanmeldung WO98/06243 ist ein Verfahren zur Herstellung von geschirmten Leiterbahnen auf Leiterplatten bekannt. Die Leiterplatte besteht aus einer flexiblen Leiterplatte, die beidseitig mit dielektrischen Klebefolien bedeckt ist. Die Klebefolien weisen jeweils eine Kupferschicht auf. Auf der flexiblen Leiterplatte ist ein Signalleiter angeordnet, der parallel zwischen zwei Abschirmungsleitern verläuft.

Die Offenlegungsschrift DE 44 25 803 A1 betrifft eine Leiterplatte mit kostengünstigen, hochbelastbaren Strompfaden. Hierzu ist eine Leiterbahn mit einem aufgelöteten Metallstreifen verstärkt. Ein solcher Metallstreifen kann über den Rand der Leiterplatte ragen, um als herkömmliche Flachsteckzunge zu dienen.

Der Erfindung liegt demgemäß die Aufgabe zugrunde, eine Leiterplattenanordnung mit mehrpoligem Steckverbinder der gattungsgemäßen Art so weiterzubilden, daß unter Erzielung einer guten Abschirmwirkung eine konstruktiv einfache und kompakte Ausgestaltung des Steckverbinders erreicht wird.

Diese Aufgabe wird durch die im Kennzeichnungsteil des Anspruches 1 angegebenen Merkmale gelöst. So beansprucht der Steckverbinder durch die parallel zu einer Platinenlage aufliegende Befestigung der Steckerpins auf der jeweiligen Signalleiterbahn in Höhenrichtung zur Platine keinen nennenswerten Raum, was der Kompaktheit besonders zugute kommt. Für eine gute Abschirmwirkung sorgt die wechselweise Seite-an-Seite-Anordnung der Signal- und Masseleiterbahnen auf der Platinenlage und die zusätzlich vorgesehene Masseschirmfläche auf einer benachbarten Platinenlage. Hierbei ist von Vorteil, daß alle Leiterbahnen und die Masseschirmfläche in üblicher Fertigungstechnologie für das Aufbringen von Leiterbahnen auf Platinen, also ohne zusätzlichen Fertigungsaufwand angebracht werden können. Insgesamt sind also alle Komponenten im Steckerbereich optimal zu plazieren, was in der Praxis zu einer Verbesserung der sogenannten elektromagnetischen Verträglichkeit bezüglich Ein- und Abstrahlung um mehr als 20 dB führen kann. Ferner kann die beim Stand der Technik vorgesehene Schirmkammer - z. B. der in der EP 0 563 071 B1 beschriebene Vorraum zur Durchführung der Steckerpins - komplett entfallen.

Bevorzugte Ausführungsformen der Erfindung sind in den Unteransprüchen angegeben.

Ein Ausführungsbeispiel einer erfindungsgemäßen Leiterplattenanordnung mit mehrpoligem Steckverbinder wird im folgenden anhand der beigefügten Zeichnungen näher erläutert. Es zeigen:
- Fig. 1: eine schematische ausschnittsweise Draufsicht auf eine Leiterplattenanordnung mit mehrpoligem Steckverbinder, und
- Fig. 2: einen Schnitt durch die Anordnung entlang der Schnittlinie II-II nach Fig. 1.

In den Zeichnungen ist eine zweilagige Platine 1 mit einem Substrat aus PCB-Material ausschnittsweise im Bereich eines mehrpoligen Steckverbinders 2 gezeigt. Auf der obengelegenen Platinenlage 3 sind drei Signalleiterbahnen 4.1, 4.2, 4.3 rechtwinklig bis an den Rand 5 der Platine 1 parallel mit Abstand zueinander herangeführt. Zwischen den Signalleiterbahnen 4.1, 4.2. bzw. 4.2, 4.3 und neben den äußeren Signalleiterbahnen 4.1, 4.3 sind Seite an Seite und parallel mit diesen Leiterbahnen die Masseleiterbahnen 6.1, 6.2, 6.3, 6.4 wechselweise mit diesen Signalleiterbahnen 4 angeordnet. Die Masseleiterbahnen 6 enden in einem Abstand 7 vom Rand 5 der Platine 1.

Auf der Platinenlage 3 liegen flach und parallel zu den Signalleiterbahnen 4.1., 4.2., 4.3 Steckerpins 8.1, 8.2, 8.3 auf, die zur elektrischen Kontaktierung flächig auf den Signalleiterbahnen 4.1, 4.2, 4.3 verlötet sind. Die über den Rand 5 hinausstehenden Enden 9 der Steckerpins 8 dienen dabei zum Einstecken in eine entsprechenden Buchsenanordnung.

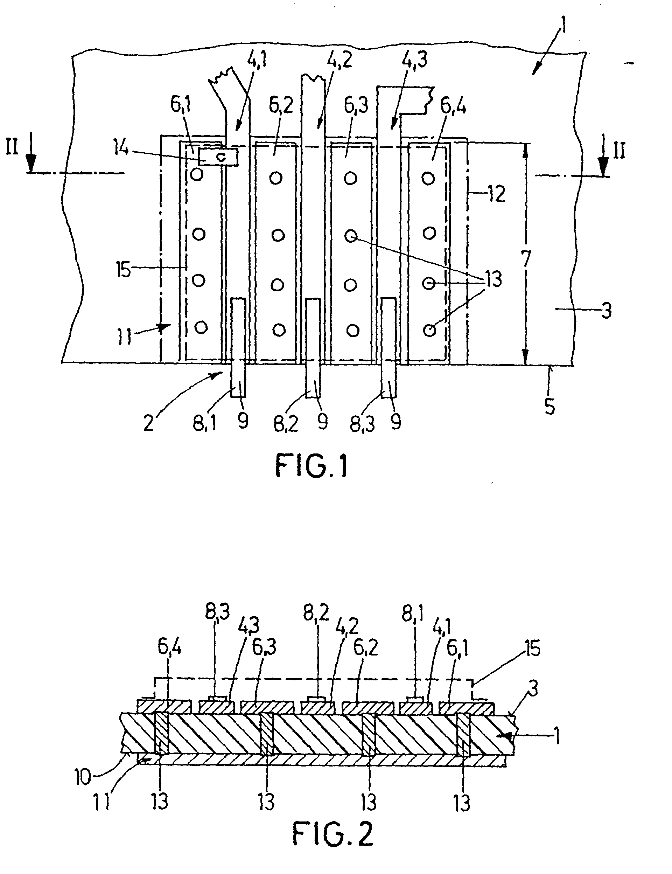

Wie insbesondere aus Fig. 2 deutlich wird, ist auf der der oberen Platinenlage 3 abgewandten unteren Platinenlage 10 eine Masseschirmfläche 11 vorgesehen, die den von den Signal- 4 und Masseleiterbahnen 6 eingenommenen Flächenbereich überdeckt. Dies wird aus der in Fig. 1 strichpunktiert eingezeichneten Kontur 12 der Masseschirmfläche 11 deutlich. Die Masseschirmfläche 11 ist mit jeder Masseleiterbahn 6.1, 6.2, 6.3 und 6.4 mehrmals über Durchkontaktierungen 13 durch die Platine 1 elektrisch verbunden. Die Masseschirmfläche kann auch auf einer Innenlage bei mehrlagigen Platinen realisiert sein.

Wie der Übersichtlichkeit halber nur in einem Beispiel in Fig. 1 dargestellt ist, ist zwischen der Signalleiterbahn 4.1 und der Masseleiterbahn 6.1 auf der dem Steckerpin 8.1 abgewandten Seite des Steckverbinders 2 ein Filterkondensator 14 geschaltet. Durch solche Filterkondensatoren 14 zwischen entsprechenden Signal-Masseleiterbahn-Paaren am Ende der Masseleiterbahnen 6 werden niederimpedante, bis in den hohen Frequenzbereich wirkende parasitäre Kapazitäten zwischen den Signalleiterbahnen 4 und Masseleiterbahnen 6 aufgebaut. Die Kopplungswege für hochfrequente Störungen beschränken sich damit hauptsächlich auf den Bereich zwischen den Signalleiterbahnen 4 und den dazwischen und darunterliegenden Massebereichen in Form der Masseleiterbahnen 6 und Masseschirmfläche 11 im Bereich des Steckverbinders 2.

Zur Verbesserung der Abschirmungseigenschaften kann schließlich - in den Zeichnungen strichliert angedeutet - noch eine Abschirmplatte 15 vorgesehen sein, die die Signalleiterbahnen 4.1, 4.2, 4.3 im Bereich des Steckverbinders 2 überspannt und auf den beiden äußeren Masseleiterbahnen 6.1, 6.4 befestigt und elektrisch damit verbunden ist.

Es ist darauf hinzuweisen, daß bei mehrlagigen oder sogenannten Multilayer-Platinen entsprechende Signalleiterbahnen und Masseleiterbahnen auf den jeweils äußeren Platinenlagen 3, 10 angeordnet sein können. Die Masseschirmfläche 11 befindet sich dann auf einer oder beiden der diesen beiden Steckverbinderbereichen benachbart liegenden inneren Platinenlagen.

## Patentansprüche

1. Leiterplattenanordnung mit mehrpoligem Steckverbinder, umfassend
A. eine mindestens zweilagige Platine (1),
B. mehrere Signalleiterbahnen (4) im Randbereich einer Platinenlage (3),
C. mehrere, jeweils einer Signalleiterbahn (4) zugeordnete Steckerpins (8),
D. den Signalleiterbahnen (4) zugeordnete Masseleiterbahnen (6) auf der Platinenlage (3), und
E. mindestens einen Filterkondensator (14) zwischen Signal- (4) und Masseleiterbahnen (6),
**gekennzeichnet durch**,
F. eine zur Platinenlage (3) parallel aufliegende Befestigung der Steckerpins (8) auf der jeweiligen Signalleiterbahn (4),
G. eine zueinander im wesentlichen parallele, wechselweise Seite-an-Seite-Anordnung der Signal-(4) und Masseleiterbahnen (6) auf der einen Platinenlage (3), und
H. eine den Flächenbereich der Signal-(4) und Masseleiterbahnen (6) überdeckende Masseschirmfläche (11) auf einer benachbarten Platinenlage (10).

2. Leiterplattenanordnung mit Steckverbinder nach Anspruch 1, **dadurch gekennzeichnet, daß** die Masseleiterbahnen (6) und die Masseschirmfläche (11) über Durchkontaktierungen (13) durch die Platine (1) elektrisch miteinander verbunden sind.

3. Leiterplattenanordnung nach Anspruch 2, **dadurch gekennzeichnet, daß** jede Masseleiterbahn (6) über mehrere Durchkontaktierungen (13) mit der Masseschirmfläche (11) elektrisch verbunden ist.

4. Leiterplattenanordnung mit Steckverbinder nach einem der Ansprüche 1 bis 3, **dadurch gekennzeichnet, daß** die Filterkondensatoren (14) auf der den Steckerpins (8) abgewandten Seite der Signalleiterbahnen (4) zwischen die Masse- und Signalleiterbahnen (6, 4) geschaltet sind.

5. Leiterplattenanordnung mit Steckverbinder nach einem der Ansprüche 1 bis 4, **dadurch gekennzeichnet, daß** die Seite-an-Seite-Anordnung von Signal- (4) und Masseleiterbahnen (6) von einer Abschirmplatte (15) überdeckt ist, die auf der der Masseschirmfläche (11) abgewandten Seite der Signal- (4) und Masseleiterbahnen (6) angeordnet ist.

6. Leiterplattenanordnung mit Steckverbinder nach Anspruch 5, **dadurch gekennzeichnet, daß** die Abschirmplatte (15) auf den beiden äußeren der Masseleiterbahnen (6.1, 6.4) befestigt und elektrisch damit verbunden ist.

7. Leiterplattenanordnung mit Steckverbinder nach einem der Ansprüche 1 bis 6, **dadurch gekennzeichnet, daß** bei mehrlagigen Platinen Steckerpins mit zugeordneten Signal- und Masseleiterbahnen auf den beiden äußeren Platinenlagen angeordnet sind, wobei mindestens eine zugehörige Masseschirmfläche auf den inneren Platinenlagen angeordnet ist.

## Claims

1. Printed circuit board arrangement with a multipole plug-in connector, comprising
A. a board (1) having at least two layers,
B. a plurality of signal conductor tracks (4) in the edge region of a board layer (3),
C. a plurality of plug pins (8) respectively assigned to a signal conductor track (4),
D. earth conductor tracks (6) on the board layer (3), said tracks being assigned to the signal conductor tracks (4), and
E. at least one filter capacitor (14) between signal (4) and earth conductor tracks (6),
**characterized by**
F. a fixing of the plug pins (8) on the respective signal conductor track (4), said fixing bearing parallel to the board layer (3),
G. an alternate side-to-side arrangement of the signal (4) and earth conductor tracks (6), essentially parallel to one another, on said board layer (3), and
H. a earth screening surface (11) on an adjacent board layer (10), said surface covering the surface region of the signal (4) and earth conductor tracks (6).

2. Printed circuit board arrangement with a plug-in connector according to Claim 1, **characterized in that** the earth conductor tracks (6) and the earth screening surface (11) are electrically connected to one another via plated-through holes (13) through the board (1).

3. Printed circuit board arrangement according to Claim 2, **characterized in that** each earth conductor track (6) is electrically connected to the earth screening surface (11) via a plurality of plated-through holes (13).

4. Printed circuit board arrangement with a plug-in connector according to one of Claims 1 to 3, **characterized in that** the filter capacitors (14) are connected between the earth and signal conductor tracks (6, 4) on that side of the signal conductor tracks (4) which is remote from the plug pins (8).

5. Printed circuit board arrangement with a plug-in connector according to one of Claims 1 to 4, **characterized in that** the side-to-side arrangement of signal (4) and earth conductor tracks (6) is covered by a screening plate (15), which is arranged on that side of the signal (4) and earth conductor tracks (6) which is remote from the earth screening surface (11).

6. Printed circuit board arrangement with a plug-in connector according to Claim 5, **characterized in that** the screening plate (15) is fixed on the two outer earth conductor tracks (6.1, 6.4) and electrically connected thereto.

7. Printed circuit board arrangement with a plug-in connector according to one of Claims 1 to 6, **characterized in that**, in the case of multilayer boards, plug pins with assigned signal and earth conductor tracks are arranged on the two outer board layers, at least one associated earth screening surface being arranged on the inner board layers.

## Revendications

1. Arrangement pour carte à circuit imprimé comportant un connecteur enfichable multipolaire comprenant
A. une platine (1) ayant au moins deux couches,
B. plusieurs pistes conductrices de signaux (4) dans la zone de bordure d'une couche (3) de la platine,
C. plusieurs broches de connexion (8) correspondant chacune à une piste conductrice de signaux (4),
D. sur la couche (3) de la platine, des pistes conductrices de masse (6) correspondant aux pistes conductrices de signaux (4) et
E. au moins un condensateur de filtrage (14) entre les pistes conductrices de signaux (4) et les pistes conductrices de masse (6),
**caractérisé par**
F. une fixation des broches de connexion (8) sur la piste conductrice de signaux (4) correspondante appliquée parallèlement à la couche (3) de la platine,
G. une disposition alternée côte à côte et, pour l'essentiel, parallèle entre elles des pistes conductrices de signaux (4) et des pistes conductrices de masse (6) sur la couche (3) de la platine et
H. sur une couche (10) voisine de la platine, une surface écran à la masse (11) qui recouvre la zone de surface des pistes conductrices de signaux (4) et des pistes conductrices de masse (6).

2. Arrangement pour carte à circuit imprimé comportant un connecteur enfichable multipolaire selon la revendication 1, **caractérisé par le fait que** les pistes conductrices de masse (6) et la surface écran à la masse (11) sont reliées électriquement l'une à l'autre par des trous métallisés (13) à travers la platine.

3. Arrangement pour carte à circuit imprimé selon la revendication 2 **caractérisé par le fait que** chaque piste conductrice de masse (6) est reliée électriquement à la surface écran à la masse (11) par l'intermédiaire de plusieurs trous métallisés (13).

4. Arrangement pour carte à circuit imprimé comportant un connecteur enfichable multipolaire selon l'une des revendications 1 à 3, **caractérisé par le fait que** les condensateurs de filtrage (14) sont connectés entre les pistes conductrices de masse et les pistes conductrices de signaux (6, 4) sur le côté opposé aux broches de connexion (8) des pistes conductrices de signaux (4).

5. Arrangement pour carte à circuit imprimé comportant un connecteur enfichable multipolaire selon l'une des revendications 1 à 4, **caractérisé par le fait que** la disposition côte à côte des pistes conductrices de signaux (4) et des pistes conductrices de masse (6) est recouverte par une plaque écran (15) qui est disposée sur le côté des pistes conductrices de signaux (4) et des pistes conductrices de masse (6) opposé à la surface écran à la masse (11).

6. Arrangement pour carte à circuit imprimé comportant un connecteur enfichable multipolaire selon la revendication 5 **caractérisé par le fait que** la plaque écran (15) est fixée et, ainsi, reliée électriquement aux deux pistes conductrices extérieures de masse (6.1, 6.4).

7. Arrangement pour carte à circuit imprimé comportant un connecteur enfichable multipolaire selon l'une des revendications 1 à 6, **caractérisé par le fait que**, dans le cas de platines multicouches, des broches de connexion, correspondant à des pistes conductrices de signaux et à des pistes conductrices de masse, sont disposées sur les deux couches extérieures de la platine, au moins une surface écran de masse correspondante étant disposée sur les couches intérieures de la platine.
